# EUROPÄISCHE PATENTANMELDUNG

(11) **EP 3 823 426 A1**
(43) Veröffentlichungstag der Anmeldung: **19.05.2021**
(21) Anmeldenummer: 20206349.1
(22) Anmeldetag: 09.11.2020
(51) Int. Cl.: H05K 7/20

(54) **VORRICHTUNG ZUM KÜHLEN VON IT-KOMPONENTEN**

(30) Priorität: 13.11.2019 DE 102019130579
(71) Anmelder: Schäfer Werke GmbH, 57290 Neunkirchen (DE)
(72) Erfinder: Franze, Andreas, 56130 Bad Ems (DE); Trepte, Wolfgang, 01665 Diera-Zehren (DE)
(74) Vertreter: Grosse, Wolf-Dietrich Rüdiger

(57) **Zusammenfassung**

Die Erfindung betrifft eine Vorrichtung zum Kühlen von IT-Komponenten durch eine in der Einbautiefe variables Kühlelement.

## Beschreibung

### Gebiet:

Die Erfindung betrifft eine Vorrichtung zum Kühlen von IT-Komponenten.

### Stand der Technik:

Bisherige Kühlelementen weisen immer feste Abmessungen in Bezug auf die Einbautiefe auf. Dadurch können funktionstüchtige Kühlgeräte bei einem Wechsel des Serverracks ggf. nicht mehr weiterverwendet werden. Darüber hinaus müssen für eine Vielzahl von unterschiedlichen Bautiefen von existierenden Serverracks unterschiedliche Kühlelemente gebaut bzw. vorrätig gehalten werden.

### Aufgabe der Erfindung:

Aufgabe der Erfindung ist es die Bauweise von Kühlgeräten zum Kühlen von IT-Komponenten, insbesondere von IT-Komponenten in Serverracks dahingehend weiterzuentwickeln, dass diese in ihrer Einbautiefe variabel angepasst werden können.

### Erfindung:

Die Aufgabe der Erfindung wird durch eine Vorrichtung mit den Merkmalen des Anspruchs 1 gelöst. Die Vorrichtung weist mindestens ein Ventilatormodul mit mindestens einem Ventilator zum Fördern von Luft durch das Ventilatormodul und mindestens ein Wärmeübertragungsmodul zum Austausch von Wärme zwischen der Luft und dem externen Medium auf. Das mindestens eine Ventilatormodul und mindestens eine Wärmeübertragungsmodul sind gegeneinander verschiebbar miteinander verbunden und durch das Ventilatormodul ist Luft zu dem mindestens einen Wärmetauscher des mindestens einen Wärmeübertragungsmoduls hin förderbar.

Weitere bevorzugte Ausführungen der Vorrichtung sind in den abhängigen Ansprüchen 2 bis 14 dargestellt.

Bevorzugt ist, dass das mindestens eine Ventilatormodul in das mindestens eine Wärmeübertragungsmodul oder das mindestens eine Wärmeübertragungsmodul in das mindestens eine Ventilatormodul einschiebbar ist. Hierdurch kann auf einfache Weise ein in der Einbautief variabel luftleitendes Kühlelement konstruiert werden. Ebenfalls können auf einfache Weise der bei dieser Form auftretende Spalt zwischen den Elementen gegen einen Ein- bzw. Austritt von Luft abgedichtet werden.

Das Wärmeübertragungsmodul weist mindestens zwei Anschlüsse für das wenigstens eine externe Medium, vorzugsweise Wasser oder Kältemittel, für eine Zu- bzw. Abfuhr des externen Mediums auf. Vorteilhaft ist hierbei, dass das Wärmübertragungsmodul nicht auf einer Außenseite eines IT-Racks aufbaut und dadurch die IT-Racks enger beieinander aufgestellt werden können. Dadurch wird der Aufstellplatz bei der Kombination von mehreren Serverracks reduziert.

In mindestens einem Wärmetauscher des Wärmeübertragungsmoduls sind verschiedene externe Medien verwendbar. Diese Ausführung ist bevorzugt, weil dadurch fertige IT-Racks in unterschiedlichen klimatischen Regionen verwendet werden können, ohne dass der Wärmetauscher und / oder das Wärmeübertragungsmodul getauscht oder geändert werden muss.

In einem Wärmeübertragungsmodul sind bevorzugt mindestens zwei Wärmetauscher für die parallele Verwendung von verschiedenen externen Medien vorhanden. Hieraus ergibt sich der Vorteil, dass in Abhängigkeit von der benötigten Leistung, Kühl- oder Heizleistung, und / oder Umgebungstemperatur unterschiedliche externe Medien und deren verbundenen Rückkühleinrichtungen genutzt werden können. Dadurch ist vorteilhafterweise möglich den Energiebedarf der gesamten Servereinrichtung zu reduzieren.

Eine Steuerung oder Regelung für die Zu- bzw. Abfuhr des externen Mediums des Wärmeübertragungsmoduls ist idealerweise vorhanden. Hierdurch kann der Wärmestrom durch den Wärmetauscher hindurch gesteuert oder geregelt werden. Dadurch können die IT-Komponenten auf der idealen Betriebstemperatur gehalten werden und / oder auf schwankende Temperaturverhältnisse reagiert werden.

Die Vorrichtung ist bevorzugt zwischen die Außenwand und Einbauebenen eines Racks einbaubar. Dadurch gehen keine Einbauebenen für IT-Komponenten in einem Serverrack für Wärmeübertrager verloren. Bei gleicher Serverrackgröße können mehr IT-Komponenten verbaut werden und die ideale Betriebstemperatur bleibt durch die erfindungsgemäße Vorrichtung sichergestellt.

Vorzugsweise ist mindestens ein Mikrowärmetauscher als Wärmetauscher im Wärmeübertragungsmodul vorhanden. Hierdurch kann mehr Wärme pro Zeit bei gleicher Baugröße des Wärmetauschers übertragen werden. Dadurch können beispielsweise abwärmeintensivere IT-Komponenten im Serverrack verbaut werden. Darüber hinaus können durch die große Oberfläche der Mikrowärmetauscher die Server mit sehr hohen Temperaturdifferenzen des Kühlmediums im Wärmetauscher betrieben werden, so dass beispielsweise ein großer Betriebszeitanteil im Jahr mit energiesparender Freikühlung in den Rückkühleinrichtungen möglich ist.

Die Einbautiefe der Vorrichtung im Einbauzustand ist vorzugsweise in einem Bereich von 150 mm bis 2000 mm, besonders vorzugsweise 600 mm bis 1800 mm, noch mehr bevorzugt, 850 mm bis 1400 mm variierbar. Hierdurch kann die Vorrichtung auf alle aktuell vorhandenen Bauformen von Serverracks angepasst werden.

Das Ventilatormodul weist vorzugsweise mehr als einen Ventilator, besonders vorzugsweise mehr als zwei, noch mehr bevorzugt mehr als drei Ventilatoren auf. Hierdurch wird sichergestellt, dass die Luft im Serverrack gleichmäßig umgewälzt wird und ein gleichmäßige Temperaturverteilung im Serverrack vorherrscht.

Das Ventilatormodul weist bevorzugt eine Steuerung oder Regelung für die durch das Ventilatormodul geförderte Luftmenge auf. Daraus ergibt sich der Vorteil, dass die Leistungsaufnahme der Ventilatoren an die notwendige umzuwälzende Luftmenge angepasst werden kann. Hierdurch sinkt der Energieverbrauch der Ventilatoren bei der Luftumwälzung. Weiterhin kann auf einfache Weise ein Bypass für die Kühlung der elektronischen Steuerung oder Regelung verwendet werden.

Durch den Ventilator ist idealerweise Luft aus dem Innenraum des Serverracks ansaugbar und die Luft ist bevorzugt zuerst durch das Wärmeübertragungsmodul und anschließend durch das Ventilatormodul durch den Ventilator förderbar. Hierdurch kann die Steuerung oder Regelung der Ventilatoren gleichzeitig mit den IT-Komponenten auf Betriebstemperatur gehalten werden.

Die Regelung oder Steuerung des Ventilatormoduls ist bevorzugt mit der Regelung oder Steuerung des Wärmeübertragungsmoduls gekoppelt. Durch die verbundene Steuerung oder Regelung kann der Energieverbrauch noch weiter gesenkt werden, da bei Betriebszuständen in denen keine Kühlung oder Heizung benötig wird, die entsprechenden Module nicht genutzt werden oder die Leistung entsprechend reduziert wird.

Der Beschreibung sind die folgenden sechs Figuren beigefügt:
- Fig. 1:: Ansicht eingebautes Kühlelement in ein Serverrack
- Fig. 2:: Mehrere Racks mit einem Kühlelement
- Fig. 3:: Sicht von oben auf eingebautes Kühlelement
- Fig. 4:: Ventilatormodul und Wärmeübertragermodul getrennt von einander
- Fig. 5:: Kühlelement in verschiedenen Einbautiefen
- Fig. 6:: Bypass für Kühlung der Steuerung oder Regelung

Die Erfindung wird nachfolgend unter Bezugnahme auf die genannten Figuren in Form von Ausführungsbeispielen detailliert beschrieben. In allen Figuren sind gleiche technische Elemente mit gleichen Bezugszeichen bezeichnet.

### Figurenbeschreibung:

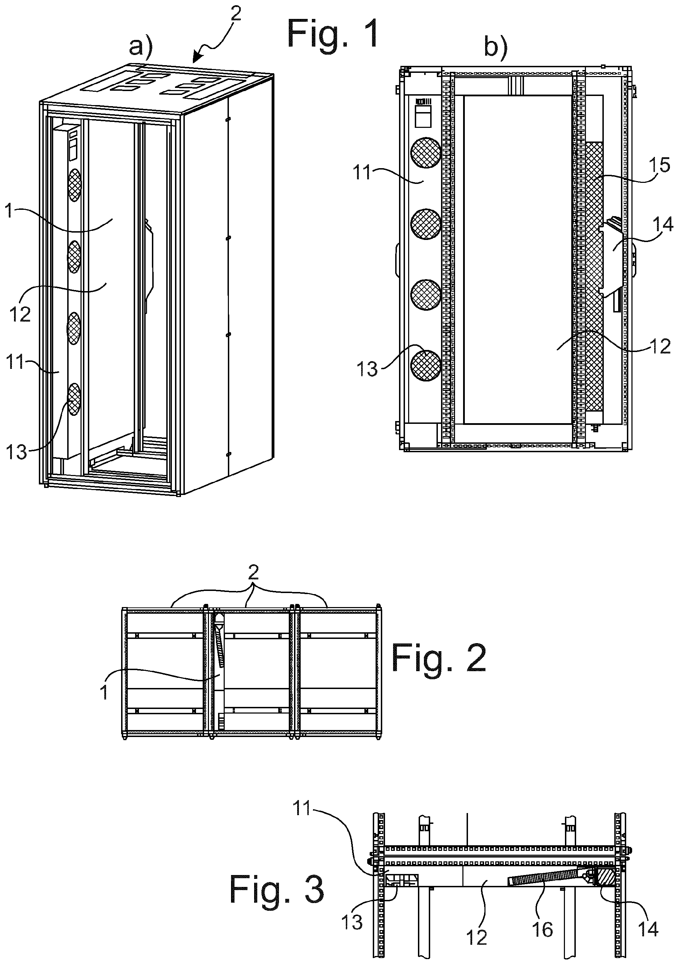

*Figur 1a**)* zeigt eine dreidimensionale Darstellung eines Serverracks 2 mit einem eingebauten Kühlelement 1 und die dazugehörende Seitenansicht, *Figur 1b**).* Das Kühlelement 1 ist an der Seitenwand des Serverracks 2 angebracht. Die Luft wird im hinteren Bereich des Serverracks 2 durch eine Ansaugöffnung 15 angesaugt und durch die Öffnungen an den Ventilatoren 13 ausgeblasen. In *Figur 2* wird eine mögliche Aufstellung von drei Serverracks 2 nebeneinander mit einem Kühlelement 1 in der Draufsicht dargestellt.

*Figur 3* skizziert in einem Schnitt durch ein eingebautes Kühlelement 1 eine Anordnung von einem Ventilator 13 in dem Ventilatormodul 11. Weiterhin ist ein Wärmetauscher 16 in dem Wärmeübertragungsmodul 12 dargestellt. Dieser ist diagonal versetzt zur Außenwand des Wärmeübertragungsmoduls 12 verbaut. Die Anschlüsse für das Medium des Wärmetauschers 16 sind zur Rückseite des Serverracks 2 hin ausgerichtet.

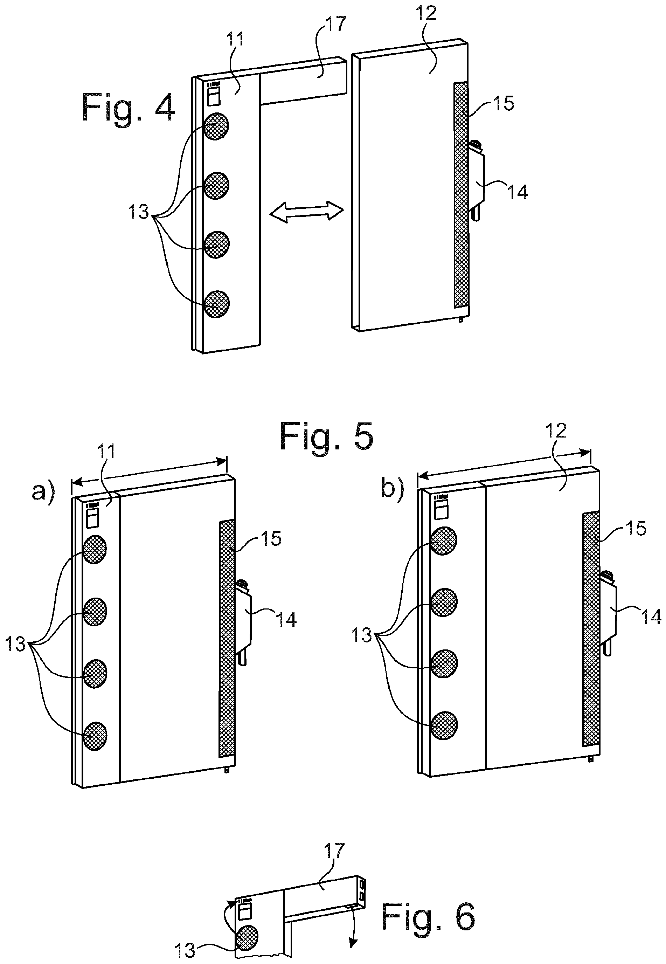

In *Figur 4* sind die beiden Module 11, 12 voneinander getrennt dargestellt. Das Ventilatormodul 11 ist L-förmig aufgebaut, wobei im schmalen Schenkel des L die Elektronik der Steuerung bzw. Regelung 17 untergebracht ist. Die untere Seite der Elektronik 17 wird von der vorbeigeförderten Luft gekühlt. Gleichzeitig dient der Schenkel 17 als Führung und vereinfacht das Zusammenschieben der Module 11,12.

Zwei unterschiedliche Einbautiefen t des Kühlelementes 1 sind in *Figur 5* dargestellt. In Figur 5a) ist die Einbautiefe t geringer als in Figur 5b)

*Figur 6* stellt einen Bypass für beispielsweise die Kühlung einer Steuerung oder Regelung 17 dar. Die kalte Luft wird in den Bauraum der Steuerung oder Regelung 17 eingesaugt oder eingeblasen. Der Auslass der Luft befindet sich im Bereich der Ansaugseite vor den Wärmetauschern 16 im Wärmeübertragermodul 12, so dass die Luft wieder durch die Wärmetauscher 16 abgekühlt werden kann.

**Tabelle 1: Bezeichnungen in Abbildungen**

| Nummer | Beschreibung |
|---|---|
| 1 | Kühlelement |
| 11 | Ventilatormodul |
| 12 | Wärmeübertragungsmodul |
| 13 | Ventilator |
| 14 | Anschlüsse für Medium |
| 15 | Ansaugöffnung für Luft |
| 16 | Wärmetauscher |
| 17 | Steuerungs- oder Regelungsbaugruppe |
| 2 | Serverrack |

## Patentansprüche

1. Vorrichtung zum Kühlen von IT-Komponenten, insbesondere von IT-Komponenten in Serverracks (2), aufweisend mindestens einen Wärmetauscher (16), Ventilatoren (13) zum Fördern der Luft und Anschlüsse (14) für wenigstens ein externes Medium, wobei
- die Vorrichtung mindestens ein Ventilatormodul (11) mit mindestens einem Ventilator (13) zum Fördern von Luft durch das Ventilatormodul (11) aufweist;
- die Vorrichtung mindestens ein Wärmeübertragungsmodul (12) zum Austausch von Wärme zwischen der Luft und dem externen Medium aufweist;
- mindestens ein Ventilatormodul (11) und mindestens eine Wärmeübertragungsmodul (12) gegeneinander verschiebbar miteinander verbunden sind;
- durch das Ventilatormodul (11) Luft zum mindestens einen Wärmetauscher (16) des mindestens einen Wärmeübertragungsmoduls (12) hin förderbar ist.

2. Vorrichtung nach Anspruch 1,
**dadurch gekennzeichnet, dass**
das mindestens eine Ventilatormodul (11) in das mindestens eine Wärmeübertragungsmodul (12) einschiebbar ist.

3. Vorrichtung nach Anspruch 1,
**dadurch gekennzeichnet, dass**
das mindestens eine Wärmeübertragungsmodul (12) in das mindestens eine Ventilatormodul (11) einschiebbar ist.

4. Vorrichtung nach einem der vorangegangenen Ansprüche,
**dadurch gekennzeichnet, dass**
das Wärmeübertragungsmodul (12) mindestens zwei Anschlüsse (14) für das wenigstens eine externe Medium, vorzugsweise Wasser oder Kältemittel, für ein Zu- bzw. Abfuhr des externen Mediums aufweist.

5. Vorrichtung nach einem der vorangegangenen Ansprüche,
**dadurch gekennzeichnet, dass**
in mindestens einem Wärmetauscher (16) des Wärmeübertragungsmoduls (12) verschiedene externe Medien verwendbar sind.

6. Vorrichtung nach einem der vorangegangenen Ansprüche,
**dadurch gekennzeichnet, dass**
in einem Wärmeübertragungsmodul (12) mindestens zwei Wärmetauscher (16) für die gleichzeitige Verwendung von verschiedenen externen Medien vorhanden sind.

7. Vorrichtung nach einem der vorangegangenen Ansprüche,
**dadurch gekennzeichnet, dass**
eine Steuerung oder Regelung für die Zu- bzw. Abfuhr des externen Mediums des Wärmeübertragungsmoduls (12) vorhanden ist.

8. Vorrichtung nach einem der vorangegangenen Ansprüche,
**dadurch gekennzeichnet, dass**
die Vorrichtung zwischen die Außenwand und Einbauebenen eines Serverracks (2) einbaubar ist.

9. Vorrichtung nach einem der vorangegangenen Ansprüche,
**dadurch gekennzeichnet, dass**
mindestens ein Mikrowärmetauscher als Wärmetauscher (16) im Wärmeübertragungsmodul (12) vorhanden ist.

10. Vorrichtung nach einem der vorangegangenen Ansprüche,
**dadurch gekennzeichnet, dass**
die Einbautiefe (t) der Vorrichtung im Einbauzustand in einem Bereich von 300 mm bis 2000 mm, vorzugsweise 600 mm bis 1800 mm, noch mehr bevorzugt, 850 mm bis 1400 mm variierbar ist.

11. Vorrichtung nach einem der vorangegangenen Ansprüche,
**dadurch gekennzeichnet, dass**
das Ventilatormodul (11) mehr als einen Ventilator (13), vorzugsweise mehr als zwei, noch mehr bevorzugt mehr als drei Ventilatoren (13), aufweist.

12. Vorrichtung nach einem der vorrangegangenen Ansprüche,
**dadurch gekennzeichnet, dass**
- durch den Ventilator (13) Luft aus dem Innenraum des Serverracks 2 ansaugbar ist; und
- die Luft zuerst durch das Wärmeübertragungsmodul (12) und anschließend durch das Ventilatormodul (11) durch den Ventilator (13) förderbar ist.

13. Vorrichtung nach einem der vorangegangenen Ansprüche,
**dadurch gekennzeichnet, dass**
das Ventilatormodul (11) eine Steuerung oder Regelung für die durch das Ventilatormodul (11) geförderte Luftmenge aufweist.

14. Vorrichtung nach einem der vorangegangenen Ansprüche,
**dadurch gekennzeichnet, dass**
die Regelung oder Steuerung des Ventilatormoduls (11) mit der Regelung oder Steuerung des Wärmeübertragungsmodul (12) gekoppelt ist.
